# FASCICULE DE BREVET EUROPEEN

(11) **EP 3 017 467 B1**
(45) Date de publication et mention de la délivrance du brevet: **17.06.2020**
(21) Numéro de dépôt: 14752943.2
(22) Date de dépôt: 01.07.2014
(51) Int. Cl.: H01L 21/60, H01L 23/485

(54) **PROCEDE D'ASSEMBLAGE DE DEUX COMPOSANTS ELECTRONIQUES, DE TYPE FLIP-CHIP PAR RECUIT UV, ASSEMBLAGE OBTENU**
VERFAHREN ZUR FLIP-CHIP-MONTAGE VON ZWEI ELEKTRONISCHEN KOMPONENTEN DURCH UV-GLÜHEN UND ERHALTENE ANORDNUNG
METHOD OF FLIP-CHIP ASSEMBLY OF TWO ELECTRONIC COMPONENTS BY UV ANNEALING, AND ASSEMBLY OBTAINED

(30) Priorité: 02.07.2013 FR 1356442
(43) Date de publication de la demande: 11.05.2016
(73) Titulaire: Commissariat à l'Energie Atomique et aux Energies Alternatives, 75015 Paris (FR)
(72) Inventeur: ALIANE, Abdelkader, 38100 Grenoble (FR); REVAUX, Amélie, 38500 Voiron (FR)
(74) Mandataire: Nony
(86) Numéro de dépôt international: PCT/IB2014/062767
(87) Numéro de publication internationale: WO 2015/001484

(56) Documents cités:
- JP-A- H03 141 656
- JP-A- 2006 269 119
- US-A- 5 037 780
- US-A- 5 829 125
- FLEISCH T H ET AL: "Reduction of copper oxides by UV radiation and atomic hydrogen studied by XPS", APPLICATIONS OF SURFACE SCIENCE, ELSEVIER BV, NL, vol. 10, no. 1, 1 janvier 1982 (1982-01-01), pages 51-62, XP027190696, ISSN: 0378-5963 [extrait le 1982-01-01]

## Description

### Domaine technique

La présente invention concerne un procédé d'assemblage de deux composants électroniques entre eux, du type à connexions verticales, plus communément appelé procédé « flip-chip » en anglais ou « puce retournée » ou « face contre face », selon lequel l'un des deux composants électroniques est retourné pour pouvoir effectuer les connexions électriques ou assemblages à la verticale.

L'invention permet d'obtenir un assemblage entre composants électroniques, dont l'un étant au moins en partie transparent aux rayonnements ultraviolet (UV), et ce quel que soit leur pas d'interconnexion et l'espacement entre ces composants.

L'invention concerne plus particulièrement l'assemblage entre une puce, par exemple réalisée en silicium et un substrat transparent aux UV, tel qu'en polyéthylène naphtalate (PEN), polyéthylène téréphtalate (PET) ou en verre.

Les substrats peuvent être avantageusement flexibles.

Par « assemblage de deux composants électroniques », on entend dans le cadre de l'invention aussi bien un assemblage de deux composants de matériaux différents, usuellement appelé hybridation, dont l'un est un matériau transparent aux UV, qu'un assemblage de deux composants réalisés dans un même matériau transparent aux UV.

En particulier, un assemblage selon l'invention peut concerner un assemblage entre une puce électronique et un substrat, tous deux pouvant être réalisés en matériau transparent aux UV.

Par « pas d'interconnexion », on entend la distance entre deux plots de connexion sur un même composant électronique.

Par « espacement entre composants», on entend l'écartement entre les deux composants en regard défini par la hauteur d'interconnexion.

Par « transparent aux rayonnements UV », on entend un matériau qui laisse passer suffisamment de rayonnement UV par transmission à travers lui pour permettre un recuit d'oxyde de cuivre directement et par réflexion sur un matériau réfléchissant aux rayonnements UV qui est agencé en regard.

### Etat de la technique

La technique dite de « Flip-Chip » est une technique bien connue pour réaliser l'interconnexion mécanique et électrique, ou assemblage entre deux composants, tel qu'entre une puce et un substrat de circuit imprimé.

Cette technique est dite « Flip-Chip » car l'un des composants, en général la puce, qui porte des conducteurs (plots) est retourné pour mettre en face-à-face avec alignement les deux composants pour permettre les opérations d'interconnexions par solidarisation entre les conducteurs et des protubérances métalliques, connues sous l'appellation en anglais « bumps », en général sous forme de billes, et formant des contacts réalisés sur l'autre composant, en général un substrat.

Selon cette technique, trois grandes catégories d'assemblage sont actuellement connues : il s'agit du brasage, de la thermocompression, avantageusement par insertion et l'utilisation d'adhésifs, tels que les ACF (acronyme anglais d' « *Anisotropic Conductive Films »).*

Dans le brasage qui est l'assemblage le plus courant, les billes, dites billes de soudure, typiquement en indium (In), sont refondues pour produire une connexion électrique. La refusion ou refonte est réalisée typiquement par ultrasons ou par un process dit de refusion, i.e. par chauffage global de l'ensemble des deux composants reportés l'un sur l'autre, par exemple en plaçant les deux composants sous une atmosphère contrôlée en température : le chauffage fait ainsi fait refondre les billes pour former les brasures d'interconnexion électrique.

Dans la plupart des cas, un adhésif isolant électrique vient remplir l'espace entre les circuits d'un composant et l'autre composant afin d'assurer une liaison mécanique forte, de réaliser un pont thermique, et pour s'assurer que les soudures ne sont pas contraintes en fonctionnement du fait du coefficient d'expansion thermique (CET) différentiel entre les deux composants.

Un inconvénient important du process de brasage est que la refusion des billes métallique nécessite de hautes températures, typiquement supérieures à 156°C, cette dernière étant la température de fusion de l'indium constituant généralement les billes. Or, ces températures ne sont pas compatibles avec les composants organiques, notamment les composants réalisés en matière plastique, telle que le polyéthylène naphtalate (PEN) ou le polyéthylène téréphtalate (PET), qui présentent des températures de transition vitreuse inférieures aux températures de fusion des matériaux de soudure constitutifs des billes. Ainsi, la température de transition vitreuse est respectivement de 120°C pour le PEN et de 70°C pour le PET. De ce fait, si l'on soumet un composant en matière plastique à la température de fusion des billes de soudure par un brasage classique, celui-ci passe à un état caoutchouteux et se déforme fortement, voire se détruit.

Un autre inconvénient important lié au report de puces en silicium ou en germanium sur des substrats en matériau plastique et flexibles, est la non-compatibilité intrinsèque de leurs coefficients d'expansion thermique (CTE).

Enfin, les coûts liés aux hautes températures nécessaires au brasage classique lors de l'hybridation de puces sont élevés.

A titre d'illustration d'un process classique de brasage, on peut citer le brevet US 7772041B2 qui décrit une méthode d'interconnexion entre deux éléments sous vide ou dans une atmosphère contrôlée avec l'utilisation d'une surface mouillable plus grande que l'autre pour la réception de billes fusibles d'indium. Cette méthode utilise un chauffage avec une température très élevée sur toute la plaque via le porte substrat.

Dans le domaine de la microélectronique, on a déjà utilisé des lampes, dites flash UV, qui émettent un rayonnement UV dans un temps très bref.

La demande de brevet US 5,829,125 décrit un procédé d'assemblage utilisant un rayonnement laser UV appliqué au travers d'un substrat transparent pour réaliser un recuit UV du matériau des plots de connexion et des protubérances disposées sur les plots.

La demande de brevet US 2011/0262657A1 décrit ainsi une méthode de fabrication d'un film mince conducteur électriquement par réduction pour les rendre conducteurs électriquement, avec un agent chimique sensible au flash UV.

Le demande de brevet US 2010/0000762A1 décrit l'utilisation d'une lampe flash UV pour transformer de l'oxyde de cuivre en nanoparticules de cuivre de résistivité électrique de l'ordre de 5×10⁻⁴ Ω.cm, entre deux zones conductrices. Un fil métallique est ajouté pour relier les deux zones conductrices et ainsi renforcer le contact électrique.

La demanderesse enfin a déposé le 21 Août 2012 sous le numéro FR 1257897 une demande de brevet portant sur une méthode d'hybridation entre deux composants par l'application d'un rayonnement ultraviolet (UV) par transmission au travers d'un des composants transparent aux UV et de ses plots de connexion sous la forme de couches transparentes aux UV, directement sur des éléments d'interconnexion à base d'oxyde de cuivre de manière à mettre en œuvre un recuit de ce dernier en cuivre. Cette méthode nécessite une étape supplémentaire de distribution d'encre isolante électriquement dans l'espacement entre composants afin de solidifier mécaniquement les deux composants hybridés.

Il existe donc un besoin pour améliorer les procédés d'assemblage entre deux composants de type Flip-chip, notamment pour s'affranchir de l'application de températures élevées à l'ensemble des deux composants pour la réalisation des interconnexions électriques entre eux.

Le but général de l'invention est de répondre au moins en partie à ce besoin.

Un but particulier de l'invention est de proposer une solution pour s'affranchir une fois l'assemblage réalisé, d'une étape supplémentaire permettant de solidifier mécaniquement l'assemblage et pour permettre une bonne évacuation de la chaleur due au fonctionnement de l'un et/l'autre des composants assemblés.

### Exposé de l'invention

Pour ce faire, l'invention a tout d'abord pour objet, un procédé d'assemblage de type Flip-Chip, entre un premier et un deuxième composants comportant chacun des plots de connexion sur une de leurs faces, dites faces d'assemblage, selon lequel on reporte les composants l'un sur l'autre par leurs faces d'assemblage de sorte à réaliser des interconnexions électriques entre les plots du premier et ceux du deuxième composant, le procédé comportant les étapes suivantes:
a/ réalisation du premier composant avec ses plots de connexion, le premier composant étant en matériau transparent aux rayonnements ultraviolets (UV) dans des zones, dites zones d'émission, définies chacune autour d'un plot, les plots du premier composant étant en matériau absorbant ou réfléchissant les rayonnements UV ;
b/ dépôt d'oxyde de cuivre (CuO) sur le premier composant au moins sur ses plots de connexion et dans les zones d'émission;
c/ réalisation du deuxième composant avec ses plots de connexion, les plots de connexion du deuxième composant étant en matériau réfléchissant les rayonnements UV et étant adaptés chacun pour focaliser par réflexion des rayonnements ultraviolets provenant d'une zone d'émission sur un des plots du premier composant, et le cas échéant sur chaque protubérance métallique formée sur un plot du deuxième composant;
d/ formation de protubérances métalliques d'interconnexion sur au moins une partie des plots du deuxième composant;
e/ alignement et report des premier et deuxième composants l'un sur l'autre par leurs faces d'assemblage;
f/ application d'un rayonnement UV au travers des zones d'émission du premier composant sur l'oxyde de cuivre déposé de manière à mettre en œuvre un recuit UV transformant l'oxyde de cuivre déposé en cuivre et, le cas échéant à faire fondre les protubérances d'interconnexion.

Autrement dit, selon l'invention, on réalise une transformation de l'oxyde de cuivre en cuivre par recuit UV, très localement dans l'espacement entre composants au moins autour des zones au droit des plots de connexion. Un tel recuit UV ne nécessite aucun chauffage global de l'assemblage, tel que celui nécessité dans un brasage selon l'état de l'art.

En outre, la focalisation des rayonnements UV par réflexion permet d'atteindre des températures élevées très localement au niveau des protubérances d'interconnexion lorsqu'elles sont présentes. Ainsi, on peut atteindre la fusion de métal de soudure utilisé classiquement, tel que l'indium, tout en la maitrisant très finement dans l'espacement entre les deux composants et au niveau des interconnexions électriques.

Aussi, le procédé selon l'invention peut être utilisé pour n'importe quel composant transparent aux UV, y compris pour des substrats en matière plastique dont la température de transition vitreuse est pourtant inférieure à la température de refusion des protubérances qui est atteinte localement. On peut notamment utiliser des substrats transparents, flexibles et à bas coût de réalisation, tels que des substrats en PEN ou en PET.

Ainsi, grâce à l'invention, il est possible d'avoir des interconnexions électriques avec une très bonne conductivité électrique par le cuivre issu de CuO et en même temps, une conductivité électrique et mécanique accrue par les protubérances refondues.

En outre, si on effectue un dépôt d'oxyde de cuivre (CuO) sous la forme d'un film ou couche continue, c'est-à-dire même dans les zones distinctes des zones d'interconnexion électrique, on peut obtenir une très bonne dissipation de la chaleur dûe à l'échauffement d'au moins un des composants en fonctionnement, tel qu'une puce, justement par la présence du film continu.

Les avantages de l'invention sont nombreux parmi lesquels on peut citer :
- l'application de faibles températures par les rayonnements UV qui permettent à la fois la transformation de l'oxyde de cuivre en cuivre et la refusion des protubérances d'interconnexion, telles que des billes d'indium ;
- la passivation directe des éléments de connexion obtenus comprenant du cuivre issu de l'oxyde de cuivre CuO et les protubérances métalliques refondues, telles que les billes d'indium refondues, par le film d'oxyde de cuivre déposé et non soumis aux rayonnements UV ;
- l'obtention d'une résistivité électrique très faible pour les interconnexions (contacts) électriques entre les deux composants.
- l'obtention d'une excellente évacuation de la chaleur générée par le fonctionnement d'au moins un des composants, tel qu'une puce en silicium, par l'intermédiaire du film de CuO qui présente un coefficient de conductivité thermique de 33W/m.K, notamment bien meilleure que l'air de coefficient de conductivité thermique conductivité égal à 0.02W/m.K;
- l'obtention une très bonne adaptation des coefficients CTE entre composants assemblés du fait du film CuO;
- la possibilité d'un faible pas d'interconnexion;
- la limitation des coûts des étapes d'assemblage pour un composant en matière plastique;
- la possibilité d'alignement des composants par la face arrière du composant transparent;
- aucune nécessité d'étape supplémentaire d'ajout d'une encre isolante dans l'espacement entre composants suivie d'une étape de recuit thermique de cette encre isolante pour solidifier mécaniquement les interconnexions comme dans la demande de brevet FR1257897;
- des interconnexions électriques et mécaniques meilleures que celles obtenues selon la demande de brevet FR1257897 grâce à la refusion des protubérances métalliques, telles que billes d'indium simultanément avec la transformation en cuivre.

Selon un mode de réalisation avantageux, le premier composant comporte un substrat en matériau transparent aux UV.

Selon un mode de réalisation avantageux, un des composants est une puce et l'autre composant est un substrat en matériau transparent surmonté du côté de sa face d'assemblage d'une couche isolante électrique et en matériau absorbant ou réfléchissant les rayonnements UV, ladite couche définissant les zones d'émission.

De préférence, le matériau constitutif de la couche définissant les zones d'émission est choisi parmi un oxyde de titane, tel que TiO₂, l'oxyde de zinc (ZnO), l'oxyde de zirconium (ZrO₂), des molécules de pyrène dissoutes dans l'acétone.

Selon un autre mode de réalisation avantageux, le premier composant est un substrat en matériau transparent surmonté du côté de sa face d'assemblage d'une couche en matériau absorbant ou réfléchissant les rayonnements UV et isolée électriquement des zones d'émission et des plots de connexion.

De préférence, le matériau constitutif de la couche isolée électriquement des zones d'émission et des plots de connexion est un métal tel que l'or (Au), le titane (Ti), le nickel (Ni).

Selon un mode de réalisation avantageux, le premier composant est un substrat en matériau transparent et selon lequel les zones d'émission sont définies par des gouttes de solvant absorbant les rayonnements UV ajoutées à de l'oxyde de cuivre (CuO).

De préférence, le solvant est choisi parmi l'eau, l'acétonitrile, le pentane, le n-héxane, le cyclohexane, le cyclopentane.

L'étape b/ est de préférence réalisée par un dépôt de CuO sous la forme d'une encre afin de constituer un film recouvrant la face d'assemblage du premier composant.

Selon une variante avantageuse, on réalise, entre les étapes e/ et f/, une étape el/ de recuit thermique de l'encre d'oxyde de cuivre (CuO) entre 90 et 100 °C pendant un durée de 10min à 30 min de manière à activer thermiquement l'oxyde de cuivre.

Selon une variante avantageuse, l'application du rayonnement UV selon l'étape f/ consiste en une impulsion photonique d'une durée comprise entre 0,5 et 2 milliseconde (ms) avec une énergie comprise entre 10 et 20 joules/cm².

L'invention a également pour objet un assemblage entre deux composants notamment obtenu selon le procédé qui vient d'être décrit.

Ainsi, l'invention concerne un assemblage entre un premier et un deuxième composant comportant chacun des plots de connexion sur une de leurs faces, dites faces d'assemblage, dans lequel :
- le premier composant est en matériau transparent aux rayonnements ultraviolets (UV) au moins dans des zones, dites zones d'émission, et comporte des plots de connexion en matériau absorbant ou réfléchissant les rayonnements UV et délimités chacun par des zones d'émission,
- le deuxième composant comporte des plots de connexion en matériau réfléchissant les rayonnements UV, les plots de connexion du deuxième composant étant adaptés chacun pour focaliser par réflexion des rayonnements ultraviolets provenant d'une zone d'émission sur un des plots du premier composant.

Selon l'invention, l'assemblage comporte :
- des zones d'interconnexion en cuivre (Cu) remplissant chacune l'espace au moins entre les zones d'émission du premier composant et un plot du deuxième composant,
- le cas échant, des protubérances métalliques refondues chacune dans une zone d'interconnexion entre un plot du premier composant et un plot (21) du deuxième composant.

Selon un mode de réalisation avantageux, le premier composant comporte un substrat en matériau transparent aux UV. Avantageusement, le substrat est en polyéthylène naphtalate (PEN), polyéthylène téréphtalate (PET) ou en verre.

Selon une autre variante avantageuse, les plots de connexion du deuxième composant ont une forme concave par rapport à la face d'assemblage, la forme concave étant constituée par une portion de cylindre ou parabolique.

Selon une autre variante avantageuse, les plots de connexion du deuxième composant ont une forme triangulaire isocèle et creuse par rapport à la face d'assemblage.

L'angle α à la base, formé entre les deux côtés du triangle isocèle et la face d'assemblage du deuxième composant, est de préférence inférieur à 40°, de préférence inférieur à 30°, de préférence encore inférieur à 10°.

Avantageusement, les plots de connexion du premier composant sont en matériau réfléchissant aux rayonnements UV.

De préférence, les plots de connexion du deuxième composant sont réalisés sous la forme d'une couche métallique dont le métal est choisi parmi l'aluminium (Al), l'or (Au), le titane (Ti), le nickel (Ni), le platine (Pt), ou d'une bicouche métallique choisie parmi le nickel surmonté d'or (Ni/Au), le nickel surmonté de platine (Ni/Pt).

De préférence également, le matériau constitutif des protubérances d'interconnexion est choisi parmi l'indium (In), un alliage aluminium-cuivre (AlCu), l'étain (Sn), un alliage or-étain (AuSn).

Selon un mode de réalisation avantageux, le deuxième composant est une puce, en particulier une puce en silicium, et le premier composant est un substrat en matériau transparent surmonté du côté de sa face d'assemblage d'une couche absorbant les rayonnements UV définissant les zones d'émission.

### Description détaillée

D'autres avantages et caractéristiques de l'invention ressortiront mieux à la lecture de la description détaillée de l'invention faite à titre illustratif en référence aux figures suivantes parmi lesquelles :
- la figure 1 est une vue schématique en coupe illustrant un assemblage de deux composants après leur assemblage l'invention;
- les figures 1A est une vue de détail de la figure 1;
- les figures 2 et 3 sont des vues schématiques en coupe illustrant le trajet optique des rayons issus de la réflexion par réflexion d'un rayonnement UV selon une étape du procédé selon l'invention, l'étape étant mise en œuvre avec des plots de connexion en matériau réfléchissant respectivement de forme triangulaire isocèle et de forme en portion de cylindre;
- les figures 4A à 4F sont des vues schématiques en coupe illustrant différentes focalisations par réflexion d'un rayonnement UV selon une étape du procédé selon l'invention, l'étape étant mise en œuvre avec des plots de connexion en matériau réfléchissant de forme triangulaire isocèle selon différents angles à la base;
- les figures 5A et 5B sont des vues schématiques en coupe illustrant différentes focalisations par réflexion d'un rayonnement UV selon une étape du procédé selon l'invention, l'étape étant mise en œuvre avec des plots de connexion en matériau réfléchissant de forme en portion cylindrique;
- les figures 6A à 6G sont des vues schématiques en coupe et de détail illustrant les différentes étapes de réalisation d'un procédé selon l'invention.

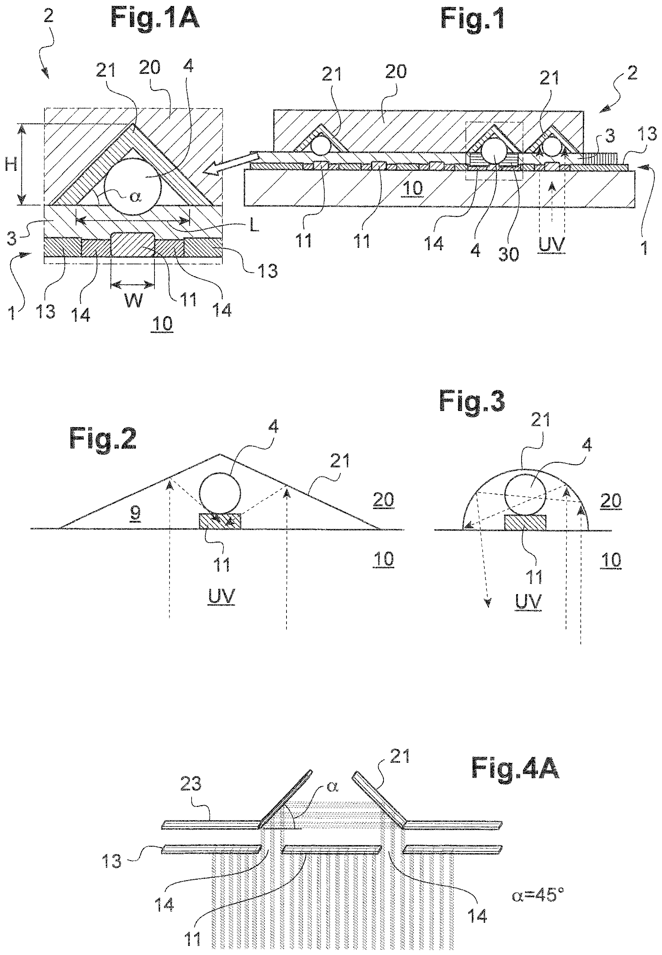

On a représenté en figures 1 et 1A un assemblage entre deux composants électroniques 1, 2, tels qu'entre un composant 1 avec substrat 10 flexible en PEN ou en PET et une puce électronique 2 en silicium, avant qu'il ait subi un rayonnement UV conformément à l'invention.

Le composant 1, qui est celui retourné, comporte un substrat 10 transparent aux rayonnements UV sur la face d'assemblage 12 duquel des plots de connexion 11 de même hauteur ont été réalisés. A titre d'exemple, la largeur W d'un plot de connexion 11 est d'environ 40 µm.

Entre deux plots 11 de connexion est déposée une couche 13 en matériau isolant électrique et absorbant les rayonnements UV. Cette couche 13 définit autour de chaque plot de connexion 11, une zone d'émission 14 apte à laisser passer les rayonnements UV.

Le composant 2, qui est celui retourné, comporte quant à lui un substrat 20 en silicium sur la face d'assemblage 12 duquel des plots de connexion 21 de même hauteur ont été réalisés. Les plots de connexion 21 sont en matériau réfléchissant les UV. La forme géométrique de chaque plot de connexion est un triangle isocèle avec un angle à la base α de préférence inférieur à 40° comme précisé par la suite. A titre d'exemple, la largeur L de la base du triangle d'un plot 21 est égale à environ 60 µm et la hauteur H du triangle d'un plot 21 est égale à 10 µm.

Chacun des plots de connexion 21 est surmonté d'une protubérance métallique de connexion 4 sous la forme d'une bille en matériau fusible. Typiquement, il s'agit d'une bille d'indium 4. Entre deux plots 21 de connexion est déposée une couche 23 en matériau isolant électrique et absorbant les rayonnements UV.

Le pas d'interconnexion entre deux plots consécutifs 21 est au minimum égal à 40 µm.

Comme mieux visible en figure 1A, une couche 3 continue d'oxyde de cuivre CuO a été déposée sur les plots de connexion 11 et sur la couche 13 en matériau isolant électrique et absorbant les UV avant le report des composants l'un sur l'autre.

Selon l'invention, pour finaliser l'assemblage une fois le report effectué d'un composant retourné 2 sur l'autre 1, on applique un rayonnement UV au travers des zones d'émission 14 du premier composant 1 sur l'oxyde de cuivre 3 déposé de manière à mettre en œuvre un recuit UV transformant l'oxyde de cuivre déposé en cuivre et à faire fondre les protubérances d'interconnexion 4. Le rayonnement UV passant à travers les zones d'émission 14 est réfléchi sur chaque plot 21 dont la forme est adaptée pour focaliser au mieux le rayonnement UV sur la protubérance 4 et sur le plot 11 de connexion.

Ainsi, on réalise une transformation localisée du CuO en Cu et la refusion simultanée des protubérances 4 dans les zones d'interconnexion 3, 4.

On obtient donc au final un assemblage avec un bon contact électrique en cuivre et en même temps électrique et mécanique par le matériau fondu des protubérances 4. On obtient également une bonne dissipation de la chaleur dûe à l'échauffement du composant 2 en fonctionnement par l'intermédiaire de la couche 3 de CuO.

Il est possible de faire varier la forme des plots 21 de connexion pour obtenir une bonne focalisation sur une protubérance de connexion 4 afin de la faire fondre ainsi que sur le plot de connexion 11 sous-jacent. Ainsi, il peut s'agir avantageusement d'une forme triangulaire isocèle (figure 2) ou d'une forme en portion de cylindre (figure 3).

On a étudié l'impact respectivement de la forme concave des plots de connexion 21, de l'angle α à la base formé entre les deux côtés du triangle isocèle et la face d'assemblage 22 du deuxième composant 2 lorsque les plots 21 sont de forme triangulaire et enfin du matériau réfléchissant ou absorbant les UV, sur leur focalisation des rayonnements UV sur les billes de connexion 4 et donc sur la possibilité ou non de faire fondre celles-ci.

Cette étude a été faite à l'aide du logiciel commercial de tracé de rayons « Trace pro 6.0». Ce logiciel est développé par Lambda Research Corp.

On a tout d'abord réalisé des simulations avec des plots 21 ayant une forme triangulaire isocèle puis on a fait varier leur angle à la base α à la base formé entre les deux côtés du triangle isocèle et la face d'assemblage 22 du deuxième composant 2.

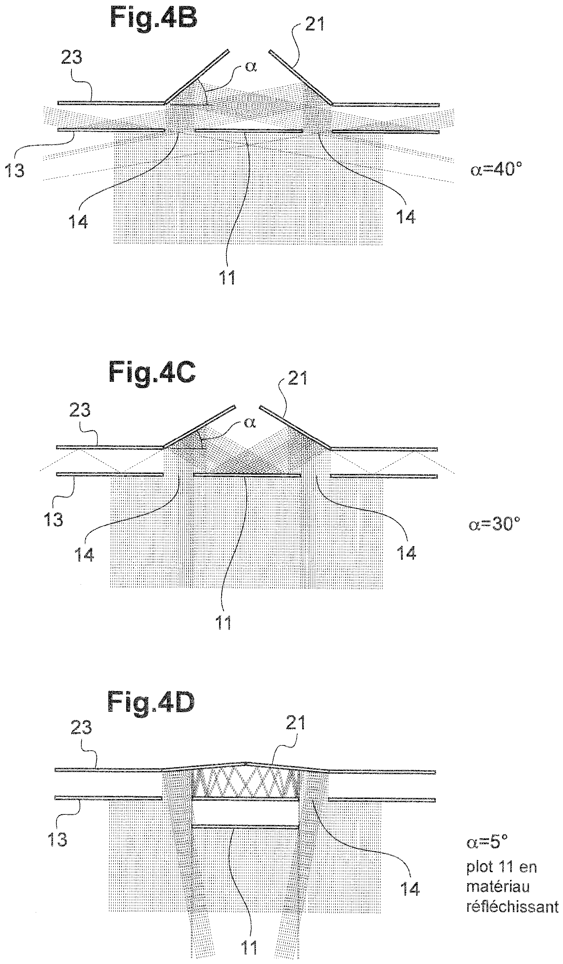

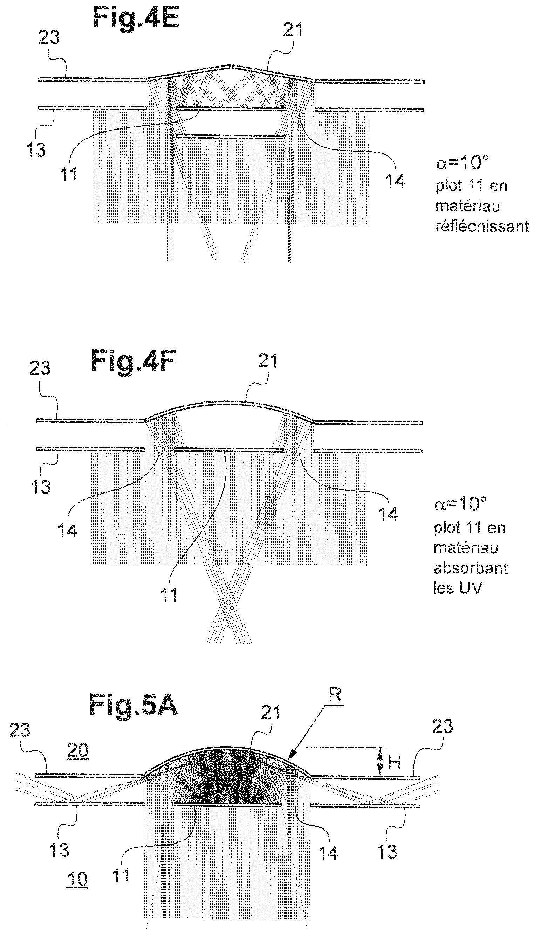

Ces simulations sont montrées respectivement aux figures 4A à 4F.

On indique dans le tableau 1 ci-après les conditions correspondantes pour chacune de ces figures ainsi que les résultats qualitatif et quantitatif de la focalisation ou non des rayonnements UV sur une zone d'interconnexion concernée 4, i.e. celles simulant l'emplacement d'une bille d'indium 4.

**TABLEAU 1**

| Figure | Valeur de l'angle α | Résultats |
|---|---|---|
| 4A | 45° | aucun rayon UV réfléchi n'arrive dans la zone 4 concernée |
| 4B | 40° | aucun rayon réfléchi sur le plot 11. Par contre, bonne focalisation sur zone 4 concernée. |
| | | Mais de nombreux rayons partent dans la couche 3 de CuO après réflexion sur le plot 21 réfléchissant |
| 4C | 30° | 48% du flux UV arrive dans la zone 4 concernée. |
| | | Quelques rayons partent dans la couche 3 de CuO |
| | | mais l'effet est marginal (réflexion sur le coin de la structure |
| 4D | 5° | 60% du flux arrive dans la zone 4 concernée à la condition que le plot 11 soit réfléchissant aux UV |
| 4E | 10° | 63% du flux arrive sur le plot 11 et sur la zone 4 concernée, avec un plot 11 réfléchissant aux UV |
| 4F | 10° | 10% du flux arrive sur le plot 11, avec un plot 11 absorbant aux UV. |
| | | Mais, les rayons n'atteignent pas le centre de la zone 4 concernée |

Ainsi, il ressort de ce tableau 1 que l'angle à la base α du triangle isocèle formé par le plot 21 doit être inférieur à 40° et que le plot 11 doit être de préférence en matériau réfléchissant les rayonnements UV.

On a fait le même type de simulations mais cette fois-ci avec des plots 21 ayant une forme en portion de cylindre.

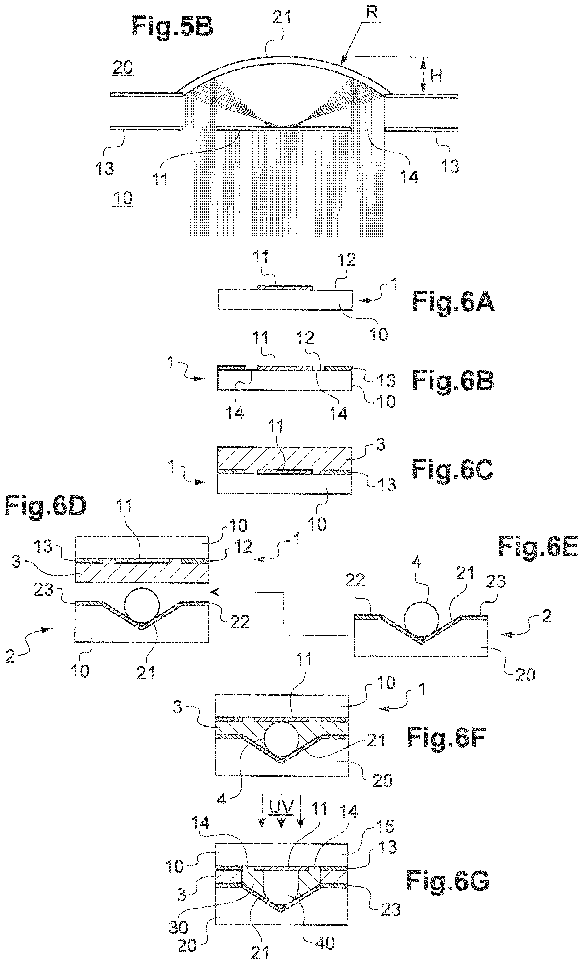

Ces simulations sont montrées respectivement aux figures 5A et 5B.

On indique dans le tableau 2 ci-après les conditions correspondantes pour chacune de ces figures ainsi que les résultats qualitatif et quantitatif de la focalisation ou non des rayonnements UV sur une zone d'interconnexion concernée 4, i.e. celles simulant l'emplacement d'une bille d'indium 4.

On précise que les dimensions de la forme 21 en portion de cylindre sont les mêmes pour les figures 5A et 5B, à savoir un rayon de courbure R égal à 50µm et une hauteur égale à 10µm.

**TABLEAU 2**

| Figure | Matériau du plot 11 | Résultats |
|---|---|---|
| 5A | réfléchissant les UV | 62% du flux arrive sur le plot 11 |
| 5B | absorbant les UV | 22% du flux arrive sur le plot 11 et en outre uniquement au centre |

Ainsi, il ressort de ce tableau 2 qu'avec une forme de plot 21 en portion de cylindre, le plot 11 doit être de préférence en matériau réfléchissant les rayonnements UV.

On décrit maintenant les différentes étapes d'assemblage selon la première alternative de l'invention en relation aux figures 6A à 6G. On précise que sur ces figures on a représenté uniquement les parties de composants 1, 2 sur lesquelles une interconnexion électrique et mécanique est obtenue par l'assemblage.

Il va de soi que l'on peut réaliser un grand nombre d'interconnexions entre les deux composants, typiquement égal à une dizaine de millier, en mettant en œuvre le procédé d'assemblage selon l'invention.

Etape a : on réalise le premier composant 1 avec ses plots de connexion 11 sur sa face d'assemblage 12, à partir d'un substrat 10 flexible en PEN ou en PET.

Pour ce faire, on réalise tout d'abord sur la face d'assemblage 12 du substrat 10, le dépôt d'une couche métallique réfléchissant les rayonnements ultraviolets, d'épaisseur de 30 à 300 nm selon une technique de dépôt physique en phase vapeur (PVD).

Le matériau constitutif de la couche peut être de l'aluminium (A1) de l'aluminium (Al). Il peut s'agir également de l'or (Au), de titane (Ti), de nickel (Ni) ou du platine (Pt).

Une fois le dépôt réalisé, on réalise sa gravure de manière à former les plots de connexion 11 (figure 6A).

La gravure peut être réalisée par voie humide ou par plasma ou par laser.

Puis, on réalise toujours sur la face d'assemblage 12, le dépôt d'une couche 13 en matériau isolant électrique et absorbant ou réfléchissant les rayonnements UV et définissant autour des plots de connexion, des zones d'émission 14 par lesquelles les rayonnements UV seront émis par la suite pour finaliser l'assemblage (figure 6B).

La couche 13 peut avoir la même épaisseur que les plots de connexion 11. La couche 13 peut être réalisée en un oxyde de titane, tel que TiO₂. Il peut s'agir également d'une couche 13 en oxyde de zinc (ZnO), de zirconium (ZrO₂), ou sous la forme de molécules de pyrène dissoutes dans l'acétone.

Etape b : on réalise alors le dépôt d'oxyde de cuivre CuO sous la forme d'une encre afin de constituer un film recouvrant 3 la face d'assemblage 12 du premier composant 1 (figure 6C).

L'encre de CuO peut être déposée par sérigraphie. A titre d'exemple, il peut s'agir de l'encre commercialisée sous la dénomination « Metalon® ICI-020 » ou encore « Metalon® ICI-021» par la société Novacentrix.

L'épaisseur de l'encre CuO déposée peut être avantageusement comprise entre 2 µm et 10µm.

Etape c : on réalise le deuxième composant 2 avec ses plots de connexion 21 sur sa face d'assemblage 22, à partir d'un puce 20 en silicium.

On réalise tout d'abord des formes triangulaires isocèles dans la puce 20 en silicium. Ces formes sont réalisées soit par une gravure isotropique, soit par voie humide, c'est-à-dire par gravure humide par hydroxyde de potassium (KOH) par exemple, soit par laser, par exemple un laser femtoseconde.

Puis, on réalise un dépôt par PVD d'une couche en matériau réfléchissant les rayonnements UV suivie d'une gravure pour former les plots de connexion 21 qui épousent les formes triangulaires isocèles.

L'épaisseur de la couche 21 déposée peut être avantageusement comprise entre 30nm et 2µm.

Puis, une fois les plots de connexion 21 formés, on réalise le dépôt d'une couche de passivation 23. Il peut s'agir d'une passivation usuelle avec l'utilisation d'une couche d'oxyde de silicium (SiO2) obtenue par oxydation thermique ou déposée par PECVD ou une couche de nitrure de silicium (Si3N4).

Etape d : on réalise le dépôt d'une bille en indium 4 sur chaque plot de connexion 21 en matériau réfléchissant les UV (figure 6D).

Le dépôt des billes d'indium 4 peut être réalisé selon une des deux méthodes connues par leur dénomination anglaise de « dispensing » ou « lift-off » suivie d'une évaporation.

Le volume unitaire d'une bille d'indium 4 peut varier entre 520 µm³ et 34000 µm³, ce qui correspond à des diamètres variant entre 10µm et 40µm.

Etape e/ : on retourne le premier composant 1, puis on met en approche et on aligne les deux composants 1,2 l'un sur l'autre de sorte à avoir chaque plot de connexion 11, 21 en regard l'un de l'autre avec l'interposition d'une bille de connexion 4 (figure 6E).

On reporte enfin le premier composant 1 sur le composant 2 de sorte à ce que chaque bille de connexion 4 vienne en contact avec un plot de connexion du premier composant 1 (figure 6F).

Etape e1/ : on effectue un recuit thermique de l'encre d'oxyde de cuivre (CuO) entre 90 et 100 °C pendant un durée de 10 min à 30 min de manière à activer thermiquement l'oxyde de cuivre.

Etape f: on applique alors un rayonnement ultraviolet bref par impulsion photonique dans une gamme de longueurs d'onde UV, au travers du substrat transparent 10 et des zones d'émission 14 (figure 6G).

La longueur d'onde UV de l'impulsion photonique peut être comprise avantageusement entre 200 et 400 nanomètres.

L'impulsion photonique UV est faite pendant une durée comprise entre 0,5 et 2 milliseconde (ms) avec une énergie comprise entre 10 et 20 joules/cm². De préférence, la durée est de 1,5 ms avec une énergie de 14 Joules/cm². Avec de telles valeurs d'énergie, un angle α de l'ordre de 10° et des plots 11 en aluminium, on réalise avec une grande fiabilité à la fois la transformation de CuO en Cu depuis la face arrière 15, opposée à la face d'assemblage 12, d'un substrat flexible en PEN ou en PET d'épaisseur de l'ordre de 125µm et la fusion de billes 4 d'indium.

En particulier, le rayonnement UV agit comme réducteur de la couche 3 de CuO déposée, ayant subi un recuit thermique selon l'étape el/, en générant de l'hydrogène H2 qui va désoxyder l'oxyde de cuivre et le transformant en cuivre avec la formation d'une molécule d'eau.

A titre d'exemple, l'impulsion photonique UV peut être produite par une lampe flash UV à Xénon, commercialisée sous la dénomination « XENON® PulseForge » par la société Xenon Corporation.

La distance séparant la lampe flash UV du substrat 10 peut être comprise entre 2 et 7 cm. Avantageusement, la distance entre la lampe et la face arrière 15 du substrat 10 est de l'ordre de 2,5 cm. Une telle distance est avantageuse car elle correspond à la distance de focalisation de l'impulsion photonique par le système optique de la lampe flash UV et donc à la distance du maximum d'énergie délivrée.

La figure 6G montre un assemblage obtenu entre les deux composants 1, 2 selon le procédé d'assemblage qui vient d'être décrit.

Les billes 40 d'indium pourtant de température de fusion supérieure à la température de transition vitreuse du substrat 10, ont été complètement refondues par focalisation par réflexion sur la couche métallique réflectrice des plots 21 et ce, sans impact néfaste sur le substrat 10.

Simultanément, l'encre 3 de CuO s'est transformée en Cu dans les zones d'interconnexion 30 définies entre la couche métallique réflectrice 21 et les zones d'émission 14.

Ainsi, les interconnexions obtenues dans les zones 30 le sont avec un bon contact électrique en cuivre et en même temps un bon contact électrique et mécanique par les billes refondues 40 sous l'énergie apportée par les UV flash.

En outre, l'assemblage obtenu permet d'évacuer efficacement chaleur qui serait dûe à l'échauffement de la puce en silicium 1 en fonctionnement par l'intermédiaire de la couche continue 3 de CuO. En particulier, le CuO a une conductivité thermique de 33W/m.K bien meilleure que l'air qui a une conductivité de 0.02W/m.K.

Ainsi, on peut envisager de réaliser l'assemblage selon l'invention entre deux circuits imprimés sur des substrats transparents flexibles en PEN ou en PET ou entre un composant en tant que détecteur sur un substrat transparent et un autre composant en tant que circuit de lecture, un capteur et un autre capteur avec l'un des deux sur un substrat transparent.

## Revendications

1. Procédé d'assemblage de type Flip-Chip, entre un premier (1) et un deuxième (2) composants comportant chacun des plots de connexion (11, 21) sur une de leurs faces, dites faces d'assemblage, selon lequel on reporte les composants l'un sur l'autre par leurs faces d'assemblage de sorte à réaliser des interconnexions électriques entre les plots du premier et ceux du deuxième composant, le procédé comportant les étapes suivantes:
a/ réalisation du premier composant avec ses plots de connexion (11), le premier composant étant en matériau transparent aux rayonnements ultraviolets (UV) dans des zones, dites zones d' émission (14), définies chacune autour d'un plot, les plots du premier composant étant en matériau absorbant ou réfléchissant les rayonnements UV ;
b/ dépôt d'oxyde de cuivre (CuO) (3) sur le premier composant au moins sur ses plots de connexion et dans les zones d'émission;
c/ réalisation du deuxième composant avec ses plots de connexion, les plots de connexion (21) du deuxième composant étant en matériau réfléchissant les rayonnements UV et étant adaptés chacun pour focaliser par réflexion des rayonnements ultraviolets provenant d'une zone d'émission, sur un des plots du premier composant, et le cas échéant sur chaque protubérance métallique formée sur un plot du deuxième composant;
d/ formation de protubérances métalliques (4) d'interconnexion sur au moins une partie des plots du deuxième composant;
e/ alignement et report des premier et deuxième composants l'un sur l'autre par leurs faces d'assemblage;
f/ application d'un rayonnement UV au travers des zones d'émission du premier composant sur l'oxyde de cuivre déposé de manière à mettre en œuvre un recuit UV transformant l'oxyde de cuivre déposé en cuivre et, le cas échéant à faire fondre les protubérances d'interconnexion.

2. Procédé d'assemblage selon la revendication 1, selon lequel le premier composant (1) comporte un substrat (10) en matériau transparent aux UV.

3. Procédé d'assemblage selon la revendication 2, selon lequel le substrat (10) en matériau transparent est surmonté du côté de sa face d'assemblage d'une couche (13) isolante électrique et en matériau absorbant ou réfléchissant les rayonnements UV, ladite couche définissant les zones d'émission (14).

4. Procédé d'assemblage selon la revendication 3, selon lequel le matériau constitutif de la couche définissant les zones d'émission est choisi parmi un oxyde de titane, tel que TiO₂, l'oxyde de zinc (ZnO), l'oxyde de zirconium (Zr02), des molécules de pyrène dissoutes dans l'acétone.

5. Procédé d'assemblage selon la revendication 2, selon lequel le substrat (10) en matériau transparent est surmonté du côté de sa face d'assemblage d'une couche (13) en matériau absorbant ou réfléchissant les rayonnements UV et isolée électriquement des zones d'émission et des plots de connexion.

6. Procédé d'assemblage selon la revendication 5, selon lequel le matériau constitutif de la couche isolée électriquement des zones d'émission et des plots de connexion est un métal tel que l'or (Au), le titane (Ti), le nickel (Ni).

7. Procédé d'assemblage selon la revendication 1, selon lequel le premier composant (1) est un substrat (10) en matériau transparent et selon lequel les zones d'émission sont définies par des gouttes de solvant absorbant les rayonnements UV ajoutées à de l'oxyde de cuivre (CuO).

8. Procédé d'assemblage selon la revendication 7, selon lequel le solvant est choisi parmi l'eau, l'acétonitrile, le pentane, le n-héxane, le cyclohexane, le cyclopentane.

9. Procédé d'assemblage selon l'une quelconque des revendications précédentes, selon lequel l'étape b/ est réalisée par un dépôt de CuO sous la forme d'une encre afin de constituer un film recouvrant la face d'assemblage du premier composant.

10. Procédé selon la revendication 9, selon lequel on réalise, entre les étapes e/ et f/, une étape el/ de recuit thermique de l'encre d'oxyde de cuivre (CuO) entre 90 et 100 °C pendant un durée de 10min à 30 min de manière à activer thermiquement l'oxyde de cuivre.

11. Procédé d'assemblage selon l'une des revendications précédentes, selon lequel l'application du rayonnement UV selon l'étape f/ consiste en une impulsion photonique d'une durée comprise entre 0,5 et 2 milliseconde (ms) avec une énergie comprise entre 10 et 20 joules/cm².

12. Assemblage entre un premier (1) et un deuxième (2) composants comportant chacun des plots de connexion (11, 21) sur une de leurs faces, dites faces d'assemblage, dans lequel :
- le premier composant est en matériau transparent aux rayonnements ultraviolets (UV) au moins dans des zones (14), dites zones d'émission, et comporte des plots de connexion (11) en matériau absorbant ou réfléchissant les rayonnements UV et délimités chacun par une zone d'émission,
- le deuxième composant comporte des plots de connexion (21) en matériau réfléchissant les rayonnements UV, les plots de connexion (21) du deuxième composant étant adaptés chacun pour focaliser par réflexion des rayonnements ultraviolets provenant d'une zone d'émission sur un des plots du premier composant,
l'assemblage comportant :
- des zones d'interconnexion (30) en cuivre (Cu) remplissant chacune l'espace au moins entre les zones d'émission (14) du premier composant et un plot (21) du deuxième composant,
- le cas échant, des protubérances métalliques (4) refondues chacune dans une zone d'interconnexion (30) entre un plot (11) du premier composant et un plot (21) du deuxième composant.

13. Assemblage selon la revendication 12, le premier composant (1) comportant un substrat (10) en matériau transparent aux UV.

14. Assemblage selon la revendication 13, le substrat (10) étant en polyéthylène naphtalate (PEN), polyéthylène téréphtalate (PET) ou en verre.

15. Assemblage selon l'une des revendications 12 à 14, les plots de connexion du deuxième composant ayant une forme triangulaire isocèle et creuse par rapport à la face d'assemblage.

16. Assemblage selon la revendication 15, l'angle α à la base, formé entre les deux côtés du triangle isocèle et la face d'assemblage du deuxième composant, étant inférieur à 40°, de préférence inférieur à 30°, de préférence encore inférieur à 10°.

17. Assemblage selon l'une des revendications 12 à 14, les plots de connexion du deuxième composant ayant une forme concave par rapport à la face d'assemblage, la forme concave étant constituée par une portion de cylindre ou parabolique.

18. Assemblage selon l'une des revendications 12 à 17, les plots de connexion du deuxième composant étant réalisés sous la forme d'une couche métallique dont le métal est choisi parmi l'aluminium (Al), l'or (Au), le titane (Ti), le nickel (Ni), le platine (Pt), ou d'une bicouche métallique choisie parmi le nickel surmonté d'or (Ni/Au), le nickel surmonté de platine (Ni/Pt).

19. Assemblage selon l'une des revendications 12 à 18, le matériau constitutif des protubérances d'interconnexion étant choisi parmi l'indium (In), un alliage aluminium-cuivre (AlCu), l'étain (Sn), un alliage or-étain (AuSn).

20. Assemblage selon l'une des revendications 12 à 19, le deuxième composant (2) étant une puce, en particulier une puce en silicium, et le premier composant (1) étant un substrat en matériau transparent surmonté du côté de sa face d'assemblage d'une couche absorbant les rayonnements UV définissant les zones d'émission.

## Patentansprüche

1. Flip-Chip-Montageverfahren einer ersten (1) und einer zweiten (2) Komponente, jeweils aufweisend Verbindungsfelder (11, 21) auf einer ihrer Flächen, den Montageflächen, wobei die Komponenten an ihren Montageflächen aufeinandergesetzt werden, um elektrische Verbindungen zwischen den Feldern der ersten und jenen der zweiten Komponente zu schaffen, das Verfahren aufweisend die folgenden Schritte:
a) Erstellen der ersten Komponente mit ihren Verbindungsfeldern (11), wobei die erste Komponente in Bereichen, den Emissionsbereichen (14), die jeweils um ein Feld herum definiert sind, aus einem Material ist, das für ultraviolette (UV-) Strahlung transparent ist, wobei die Felder der ersten Komponente aus einem Material sind, das UV-Strahlung absorbiert oder reflektiert;
b) Abscheiden von Kupferoxid (CuO) (3) auf der ersten Komponente zumindest auf ihren Verbindungsfeldern und in den Emissionsbereichen;
c) Erstellen der zweiten Komponente mit ihren Verbindungsfeldern, wobei die Verbindungsfelder (21) der zweiten Komponente aus einem Material sind, das UV-Strahlung reflektiert, und jeweils geeignet sind, ultraviolette Strahlung, die von einem Emissionsbereich kommt, durch Reflexion auf eins der Felder der ersten Komponente und gegebenenfalls auf jeden metallischen Höcker, der auf einem Feld der zweiten Komponente ausgebildet ist, zu fokussieren;
d) Bilden metallischer Verbindungshöcker (4) zumindest auf einem Abschnitt der Felder der zweiten Komponente;
e) Ausrichten und Aufeinandersetzen der ersten und zweiten Komponente an ihren Montageflächen;
f) Anwenden einer UV-Strahlung durch die Emissionsbereiche des ersten Komponente auf das abgeschiedene Kupferoxid, um ein UV-Glühen durchzuführen, welches das abgeschiedene Kupferoxid in Kupfer umwandelt, und gegebenenfalls die Verbindungshöcker schmelzen zu lassen.

2. Montageverfahren nach Anspruch 1, wobei die erste Komponente (1) ein Substrat (10) aus UV-transparentem Material aufweist.

3. Montageverfahren nach Anspruch 2, wobei das Substrat (10) aus transparentem Material auf der Seite seiner Montagefläche mit einer Schicht (13) überzogen ist, die elektrisch isolierend und aus einem Material ist, das UV-Strahlung absorbiert oder reflektiert, wobei die Schicht die Emissionsbereiche (14) definiert.

4. Montageverfahren nach Anspruch 3, wobei das Material, das die Schicht bildet, welche die Emissionsbereiche definiert, aus einem Titanoxid wie beispielsweise TiO₂, Zinkoxid (ZnO), Zirkonoxid (ZrO₂), in Azeton gelösten Pyrenmolekülen gewählt ist.

5. Montageverfahren nach Anspruch 2, wobei das Substrat (10) aus transparentem Material auf der Seite seiner Montagefläche mit einer Schicht (13) überzogen ist, die aus einem Material ist, das UV-Strahlung absorbiert oder reflektiert und von den Emissionsbereichen und den Verbindungsfeldern elektrisch isoliert ist.

6. Montageverfahren nach Anspruch 5, wobei das Material, das die Schicht bildet, die von den Emissionsbereichen und den Verbindungsfeldern elektrisch isoliert ist, ein Metall wie beispielsweise Gold (Au), Titan (Ti), Nickel (Ni) ist.

7. Montageverfahren nach Anspruch 1, wobei die erste Komponente (1) ein Substrat (10) aus transparentem Material ist und wobei die Emissionsbereiche durch Lösungsmitteltropfen definiert sind, welche die UV-Strahlung absorbieren, welche Kupferoxid (CuO) hinzugefügt werden.

8. Montageverfahren nach Anspruch 7, wobei das Lösungsmittel aus Wasser, Acetonitril, Pentan, n-Hexan, Cyclohexan, Cyclopentan gewählt ist.

9. Montageverfahren nach einem der vorhergehenden Ansprüche, wobei der Schritt b) durch ein Abscheiden von CuO in Form einer Tinte durchgeführt wird, um einen Film zu bilden, der die Montagefläche der ersten Komponente bedeckt.

10. Verfahren nach Anspruch 9, wobei zwischen den Schritten e) und f) ein Schritt e1) des Wärmebehandelns der Kupferoxid- (CuO-) Tinte zwischen 90 und 100°C für einen Zeitraum von 10 min bis 30 min durchgeführt wird, um das Kupferoxid thermisch zu aktivieren.

11. Montageverfahren nach einem der vorhergehenden Ansprüche, wobei die Anwendung der UV-Strahlung gemäß Schritt f) aus einem Photonenimpuls einer Dauer zwischen 0,5 und 2 Millisekunden (ms) mit einer Energie zwischen 10 und 20 Joules/cm² besteht.

12. Aufbau aus einer ersten (1) und einer zweiten (2) Komponente, jeweils aufweisend Verbindungsfelder (11, 21) auf einer ihrer Flächen, den Montageflächen, wobei:
- die erste Komponente zumindest in Bereichen (14), den Emissionsbereichen, aus einem Material ist, das für ultraviolette (UV-) Strahlung transparent ist, und Verbindungsfelder (11) aus einem Material aufweist, das UV-Strahlung absorbiert oder reflektiert, und die jeweils von einem Emissionsbereich begrenzt sind,
- die zweite Komponente Verbindungsfelder (21) aus einem Material aufweist, das UV-Strahlung reflektiert, wobei die Verbindungsfelder (21) der zweiten Komponente jeweils geeignet sind, UV-Strahlung, die von einem Emissionsbereich kommt, durch Reflexion auf eins der Felder der ersten Komponente zu fokussieren,
der Aufbau aufweisend:
- Verbindungsbereiche (30) aus Kupfer (Cu), die jeweils den Raum zumindest zwischen den Emissionsbereichen (14) der ersten Komponente und einem Feld (21) der zweiten Komponente ausfüllen,
- gegebenenfalls metallische Höcker (4), die jeweils in einem Verbindungsbereich (30) zwischen einem Feld (11) der ersten Komponente und einem Feld (21) der zweiten Komponente eingeschmolzen sind.

13. Aufbau nach Anspruch 12, wobei die erste Komponente (1) ein Substrat (10) aus UV-transparentem Material aufweist.

14. Aufbau nach Anspruch 13, wobei das Substrat (10) aus Polyethylennaphthalat (PEN), Polyethylenterephthalat (PET) oder aus Glas ist.

15. Aufbau nach einem der Ansprüche 12 bis 14, wobei die Verbindungsfelder der zweiten Komponente eine gleichschenkelige und hohle dreieckige Form bezogen auf die Montagefläche aufweisen.

16. Aufbau nach Anspruch 15, wobei der Winkel α an der Basis, der zwischen den zwei Seiten des gleichschenkeligen Dreiecks und der Montagefläche der zweiten Komponente gebildet ist, kleiner als 40°, vorzugsweise kleiner als 30°, noch bevorzugter kleiner als 10° ist.

17. Aufbau nach einem der Ansprüche 12 bis 14, wobei die Verbindungsfelder der zweiten Komponente eine konkave Form bezogen auf die Montagefläche aufweisen, wobei die konkave Form von einem Zylinder- oder parabolischen Abschnitt gebildet ist.

18. Aufbau nach einem der Ansprüche 12 bis 17, wobei die Verbindungsfelder der zweiten Komponente in Form einer Metallschicht, deren Metall aus Aluminium (A1), Gold (AU), Titan (Ti), Nickel (Ni) Platin (Pt) gewählt ist, oder einer Doppelmetallschicht, die aus Nickel, das mit Gold überzogen ist (Ni/Au), Nickel, das mit Platin überzogen ist (Ni/(Pt), ausgebildet sind.

19. Aufbau nach einem der Ansprüche 12 bis 18, wobei das Material, das die Verbindungshöcker bildet, aus Indium (In), einer Aluminium-Kupfer-Legierung (AlCu), Zinn (Sn), einer Gold-Zinn-Legierung (AuSn) gewählt ist.

20. Aufbau nach einem der Ansprüche 12 bis 19, wobei die zweite Komponente (2) ein Chip ist, insbesondere ein Siliziumchip, und die erste Komponente (1) ein Substrat aus transparentem Material ist, das auf der Seite seiner Montagefläche mit einer Schicht überzogen ist, die UV-Strahlung absorbiert, welche die Emissionsbereiche definiert.

## Claims

1. A process for flip-chip assembly of a first component (1) and a second component (2), each component including connection pads (11,21) on one of their faces, called their assembly faces, in which the components are added one to the other via their assembly faces so as to produce electrical interconnections between the pads of the first and those of the second component, the process including the following steps:
a/ producing the first component with its connection pads (11), the first component being made of a material that is transparent to ultraviolet (UV) radiation in zones, called emission zones (14), each of said emission zones being defined around a pad, the pads of the first component being made of a material that absorbs or reflects UV radiation;
b/ depositing copper oxide (CuO) (3) on the first component at least on its connection pads and in the emission zones;
c/ producing the second component with its connection pads, the connection pads (21) of the second component being made of a material that reflects UV radiation, each of said pads being suitable for reflectively focusing ultraviolet radiation arriving from an emission zone onto one of the pads of the first component, and, depending on the circumstances, onto each metal protuberance formed on a pad of the second component;
d/ forming interconnection metal protuberances (4) on at least some of the pads of the second component;
e/ aligning the first and second components and adding them one to the other via their assembly faces; and
f/ applying UV radiation through the emission zones of the first component to the deposited copper oxide so as to carry out a UV anneal that converts the deposited copper oxide into copper and, depending on the circumstances, makes the interconnection protuberances melt.

2. The assembly process as claimed in claim 1, in which the first component (1) includes a substrate (10) made of a material that is transparent to UV.

3. The assembly process as claimed in claim 2, in which the substrate (10) made of transparent material is surmounted, on the same side as its assembly face, with an electrically insulating layer (13) made of a material that absorbs or reflects UV radiation, said layer defining the emission zones (14).

4. The assembly process as claimed in claim 3, in which the constituent material of the layer defining the emission zones is chosen from a titanium oxide, such as TiO₂, zinc oxide (ZnO), zirconium oxide (ZrO₂) and molecules of pyrene dissolved in acetone.

5. The assembly process as claimed in claim 2, in which the substrate (10) made of transparent material is surmounted, on the same side as its assembly face, with a layer (13) made of a material that absorbs or reflects UV radiation and electrically insulated from the emission zones and connection pads.

6. The assembly process as claimed in claim 5, in which the constituent material of the layer electrically insulated from the emission zones and connection pads is a metal such as gold (Au), titanium (Ti) or nickel (Ni).

7. The assembly process as claimed in claim 1, in which the first component (1) is a substrate (10) made of transparent material and in which the emission zones are defined by drops of a solvent that absorbs UV radiation added to copper oxide (CuO).

8. The assembly process as claimed in claim 7, in which the solvent is chosen from water, acetonitrile, pentane, n-hexane, cyclohexane and cyclopentane.

9. The assembly process as claimed in any one of the preceding claims, in which step b/ is carried out by depositing CuO in the form of an ink in order to produce a film covering the assembly face of the first component.

10. The process as claimed in claim 9, in which, between steps e/ and f/, a step e1/ of thermally annealing the copper oxide (CuO) ink is carried out between 90 and 100°C for a time of 10 min to 30 min so as to thermally activate the copper oxide.

11. The assembly process as claimed in one of the preceding claims, in which the UV radiation applied in step f/ consists in a photonic pulse of a duration comprised between 0.5 and 2 milliseconds (ms) having an energy comprised between 10 and 20 joules/cm².

12. An assembly of a first component (1) and a second component (2), each component including connection pads (11,21) on one of their faces, called their assembly faces, in which:
- the first component is made of a material that is transparent to ultraviolet radiation (UV) at least in zones (14), called emission zones, and includes connection pads (11) made of a material that absorbs or reflects UV radiation, said pads each being bounded an emission zone; and
- the second component includes connection pads (21) made of a material that reflects UV radiation, each of the connection pads (21) of the second component being suitable for reflectively focusing ultraviolet radiation arriving from an emission zone onto one of the pads of the first component,
the assembly including:
- interconnection zones (30) made of copper (Cu) each filling the space at least between the emission zones (14) of the first component and a pad (21) of the second component; and
- depending on the circumstances, metal protuberances (4) each reflowed in an interconnection zone (30) between a pad (11) of the first component and a pad (21) of the second component.

13. The assembly as claimed in claim 12, the first component (1) including a substrate (10) made of a material that is transparent to UV.

14. The assembly as claimed in claim 13, the substrate (10) being made of polyethylene naphthalate (PEN), polyethylene terephthalate (PET) or of glass.

15. The assembly as claimed in one of claims 12 to 14, the connection pads of the second component having a recessed, Isosceles-triangle shape relative to the assembly face.

16. The assembly as claimed in claim 15, the angle α at the base, angle formed between the two sides of the Isosceles triangle and the assembly face of the second component, being smaller than 40°, preferably smaller than 30° and more preferably smaller than 10°.

17. The assembly as claimed in one of claims 12 to 16, the connection pads of the second component having a concave shape relative to the assembly face, the concave shape consisting of a parabolic or cylinder segment.

18. The assembly as claimed in one of claims 12 to 17, the connection pads of the second component being produced in the form of a metal layer the metal of which is chosen from aluminum (Al), gold (Au), titanium (Ti), nickel (Ni) and platinum (Pt), or of a metal bilayer chosen from nickel surmounted with gold (Ni/Au) and nickel surmounted with platinum (Ni/Pt).

19. The assembly as claimed in one of claims 12 to 18, the constituent material of the interconnection protuberances being chosen from indium (In), an aluminum-copper alloy (AlCu), tin (Sn) and a gold-tin alloy (AuSn).

20. The assembly as claimed in one of claims 12 to 19, the second component (2) being a chip, in particular a silicon chip, and the first component (1) being a substrate made of transparent material surmounted, on the same side as its assembly face, with a layer that absorbs UV radiation, defining the emission zones.
